Europäisches Patentamt

(19) European Patent Office

Office européen des brevets

(11) Publication number: **0 008 328**
**B1**

(12) **EUROPEAN PATENT SPECIFICATION**

(45) Date of publication of patent specification: **12.01.83**

(51) Int. Cl.³: **G 11 B 5/62,** C 23 C 15/00, H 01 F 10/10

(21) Application number: **79102006.8**

(22) Date of filing: **18.06.79**

(54) Amorphous magnetic films and a method of making such films.

(30) Priority: **28.08.78 US 937686**

(43) Date of publication of application:
**05.03.80 Bulletin 80/5**

(45) Publication of the grant of the patent:
**12.01.83 Bulletin 83/2**

(84) Designated Contracting States:
**BE CH DE FR GB IT NL SE**

(56) References cited:
**DE - A - 2 511 047**
**DE - B - 2 028 535**
**GB - A - 1 379 360**
**US - A - 3 965 463**
**US - A - 4 002 546**

(73) Proprietor: **International Business Machines Corporation**
**Armonk, N.Y. 10504 (US)**

(72) Inventor: **Albert, Paul Andre**
**10473 Anderson Road**
**San Jose, California 95127 (US)**
Inventor: **Heiman, Neil Duane**
**2975 Thomas Grade**
**Morgan Hill, California 95037 (US)**
Inventor: **Potter, Robert Ivan**
**11200 Canon Vista**
**San Jose, California 95127 (US)**
Inventor: **White, Robert Lee**
**23930 Jabil Lane**
**Los Altos Hills, California 94022 (US)**

(74) Representative: **Chaudhry, Mohammad Saeed**
**IBM United Kingdom Patent Operations Hursley Park**
**Winchester Hants, SO21 2JN (GB)**

Courier Press, Leamington Spa, England

Amorphous magnetic films and a method of making such films

The invention relates to a film of an amorphous magnetic material and a method of making such films.

There has been a demand for magnetic material having a high coercive force as well as high mechanical hardness for use, especially as a film for magnetic recording media. The material must be hard to resist impacts from a flying magnetic head slider and be resistant to corrosion. A thin film of a magnetic material is needed in order to increase the density of magnetic transitions formed on the magnetic material by the magnetic transducer. Particulate magnetic recording media are limited in density by the size of the magnetic materials and the binder which limits the lower level of thickness which can be accomplished.

It is known that conventional particulate ferromagnetic materials such as iron oxide and chromium dioxide are dispersed into an organic binder to form a coating layer of magnetic recording medium. However, ferromagnetic metallic thin films produced by vacuum or vapour deposition have attracted special interest because of the relative thinness of the resultant magnetic layer.

U.S. Patent 3,607,460 discloses a method of producing a magnetic recording media which includes the steps of depositing iron and rhodium as separate layers and then annealing to defuse the layers.

Further thin film magnetic recording medium comprises a magnetite film prepared by forming a film of $Fe_2O_3$ as disclosed in U.S. Patent 3,620,841.

It is known to form a magnetic film on a substrate by conventional electroplating or evaporation plating such as vapour deposition, sputtering, or ion plating. The magnetic film is made of ferromagnetic metals such as iron, cobalt and nickel or ferromagnetic alloys of ferromagnetic metals with platinum or rhodium.

It is further known that amorphous alloys can be formed having magnetic properties. For example, the article, appearing in the Journal of Applied Physics, Volume 47, No. 10, October 1976 at pages 4660—2 entitled "Low-Field Magnetic Properties of $Fe_{80}B_{20}$ Glass" by R. C. O'Handley et al., discusses the magnetic properties of metallic glasses. These magnetic glasses have extremely low coercivity which renders them unsuitable for magnetic recording media. Similar amorphous transition metal alloys such as iron carbon and iron phosphorous are very soft magnetic materials.

U.S. Patent 3 965 463 discloses amorphous magnetic materials which may be thin film, which may be multiple component or simple component (e.g. iron group transition metals) and which may include non-magnetic elements e.g. O, C, N, P in amounts generally around 2 atomic percent. Amounts greater than 50% are stated to destroy long range magnetic ordering.

According to the invention there is provided a thin film of an amorphous magnetic material characterised in that the magnetic material comprises iron-nitride in which the atomic percent of iron is from 70% to 40% and the atomic percent of nitrogen is from 30% to 60%, said film having coercivity of at least $0.8\pi$ At/m (200 oersteds) and high corrosion resistance.

Further according to the invention there is provided a method of producing a thin film of an amorphous magnetic material characterised in that the method comprises depositing onto a substrate a film of amorphous iron-nitride by diode sputter deposition of an iron-nitride target in the presence of an inert gas maintained at pressure of at least 3.33 Pa (25 $\mu$m), the atomic percent of iron in said amorphous magnetic material being 70% to 40% and the atomic percent of nitrogen in said material being 30% to 60%.

The invention will now be described by way of example with reference to the accompanying drawings in which:—

Figure 1 is a graph which illustrates the effect of gas pressure upon the coercivity ($H_c$) of the deposited film; and

Figure 2 is a graph which illustrates the corrosion behaviour of amorphous film prepared according to the present invention as compared to partially crystalline films which contain chromium.

The films to which the present invention is directed are amorphous films of iron-nitride including Fe in an atomic percent of >40 to about 70, preferably about 50 to about 70, and N in atomic percents of 30 to >60, preferably about 30 to about 50. The atomic percents are based upon the total atoms of Fe and N in the film.

It has been observed that if the atomic percent of nitrogen present in the film is less than about 30%, then the film loses its high coercivity properties. Moreover, films containing more than about 60 atomic percent nitrogen are not sufficiently magnetic to serve as magnetic recording media at room temperature.

In addition, the films produced might include relatively minor amounts of impurities (e.g., up to about 2 atomic percent). For example, minor amounts of inert gas, such as argon (e.g., up to about 2 atomic percent) employed in the sputter deposition technique, might be present in the final film. Moreover, other alloying elements including chromium can be present so long as the amounts and type can be incorporated without destroying the amorphous and magnetic characteristics of the film.

Preferably the amorphous films embodying the invention have a high coercivity of at least $1.6\pi$ At/m (400 oersteds) and magnetization

values of $4\pi M$ up to about 1.2 T (12 kgauss).

The iron-nitride amorphous films of the present invention have good mechanical hardness properties and are resistant to wear. The amorphous nature of the films offers the additional advantage of lack of media noise associated with finite grain size.

The films of the present invention can be produced by cathode diode sputter deposition onto a suitable substrate.

In sputtering techniques, the material to be deposited and the substrate upon which it is to be deposited are placed in a partial vacuum. A high potential is then applied between an electrode and the material to be deposited (e.g., metal alloy) and the gaseous ions created by the high potential strike the surface of the metal with an energy sufficient to cause atoms from the metal to enter the vapour phase; these atoms then condense to the solid state on the surface exposed to the vapour. Sputtering techniques are described in detail in "Handbook of Thin Film Technology", L. I. Maissel and R. Glang, McGraw-Hill, 1970.

The gas employed in the sputtered deposition of the films is an inert gas such as helium, neon, argon, krypton, xenon, and radon. The preferred gas is argon. In addition, the gaseous medium can contain amounts of other gases such as nitrogen; provided, the amount and type of gas are not such as to adversely affect the desired properties of the film to an unacceptable extent.

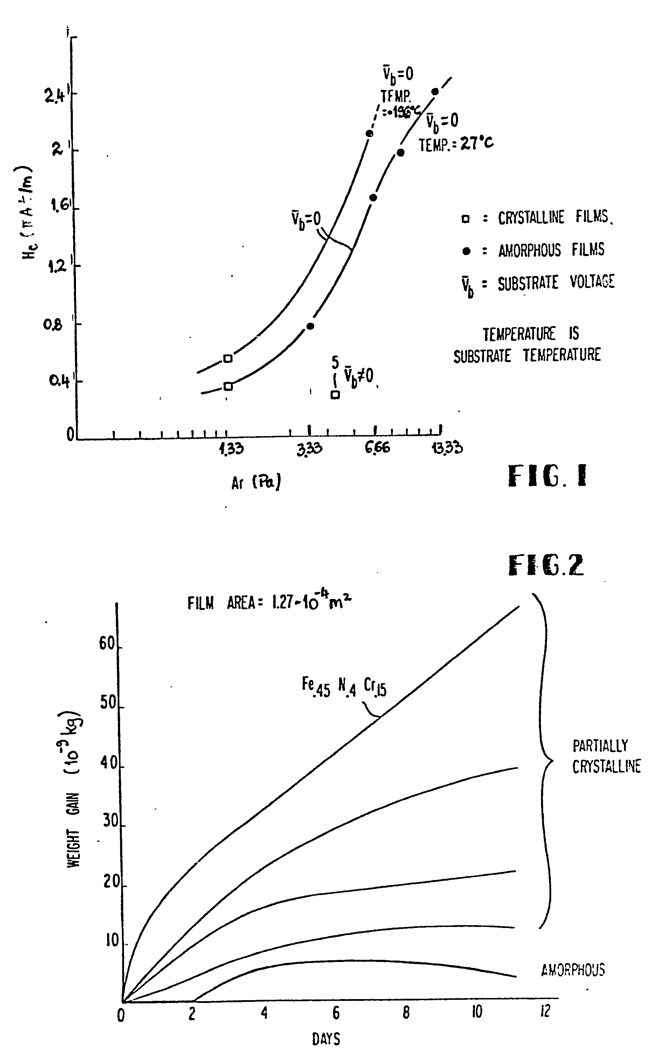

It has been observed that the coercivity of the magnetic material varies as a function of the gas pressure employed during the sputtering. Figure 1 illustrates a graph of the coercivity ($H_c$) as a function of the pressure of argon during sputter deposition. As shown in Figure 1, $H_c$ varies from less than $0.4\pi$ At/m (100 oersteds) with 1.33 Pa (10 $\mu$m) argon pressure to over 2.2 At/m (550 oersteds) with 13.33 Pa (100 $\mu$m) argon pressure for substrates at room temperature (300 K). Films deposited at low argon pressure were crystalline or partially crystalline while those deposited at higher argon pressures were amorphous as determined by X-ray diffraction. There appears to be a correlation between the amorphous nature of the film and relatively large coercivity values. When employing argon in the gas, it is preferred that the pressure be greater than about 3.33 Pa (25 $\mu$m). The maximum pressure to employ is primarily determined by practical and economical considerations. For example, pressures greater than about 13.33 Pa (100 $\mu$m) begin to cause some difficulties in the sputtering technique. Accordingly, it is preferred that the pressure be no greater than about 13.33 Pa (100 $\mu$m).

In addition, as illustrated in Figure 1, films which were deposited onto substrates at reduced temperatures −196°C (77 K) were slightly higher in coercivity than those deposited on substrates at room temperature. The temperature of the substrate during sputter deposition has a limited effect upon the coercivity of the deposited film.

Further, it has been observed that when an electrical bias is applied to the substrate, the films deposited tend to become more crystalline and accordingly lower in coercivity. Therefore, it is preferred not to bias the substrate.

Further an inert gas is employed in a method of producing the amorphous films. Films which were sputter deposited in pure nitrogen were not magnetic. It is believed that the use of pure nitrogen increased the amount of nitrogen in the deposited film to a value greater than about 60 atomic percent, which is not desirable. However, as discussed hereinabove, mixtures of inert gas and nitrogen can be employed so long as the amount of nitrogen relative to the inert gas is not so large that it results in such an increased nitrogen level in the deposited films that the film is non-magnetic.

The thickness of the film was not a significant factor with respect to the properties of the film. The thickness of the film can vary to a great extent. For example, amorphous films of the present invention of thicknesses up to about $2 \times 10^{-6}$ m (2 microns) have been deposited on quartz of about $5.08 \times 10^{-4}$ m (20 mils) thickness and glass of about $5.08 \times 10^{-5}$ m (2 mils) thickness.

Examples of suitable materials for substrates include quartz, glasses, ceramics, paper, synthetic resins such as polyethylene terephthalate, polyamides, polyimides, polyethylene, polyvinyl chloride, copolymers of vinyl chloride and vinyl acetate, copolymers of vinyl chloride and vinylidene chloride, polyvinyl alcohol, polycarbonate, polytetrafluoroethylene, polychlorotrifluoroethylene, polystyrene, rubber hydrochloride, vinyl nitrite rubber, regenerated cellulose, cellulose acetate, cellulose triacetate, cellulose acetate butyrate, cellulose nitrate, ethyl cellulose and polymethylmethacrylate, and metals or alloys such as aluminium, copper, brass, and stainless steel.

The following examples further illustrate the present invention.

### Example 1

A $Fe_{0.5}N_{0.5}$ 3″ diameter pressed powder target obtained from Cerac (Trade Mark) and a $5.08 \times 10^{-4}$ m (20 mil) quartz substrate are placed in a sputtering apparatus under an argon atmosphere at a pressure of about 13.33 Pa (100 $\mu$m). The substrate is maintained at about room temperature, about 0.0381 m (1.5″) from the target, and is at ground potential. The target is maintained at a potential of about −1500 V. The process if continued for about 2500 seconds whereby a film of about $2 \times 10^{-6}$ m (2 microns) is formed. The film is amorphous, has a coercivity of about $2.4\pi$ At/m (600 oersteds), and is represented by the formula $Fe_aN_b$ wherein a is about 0.58 and b is about 0.42.

### Example 2

Example 1 is repeated except that the argon pressure is about 10 Pa (75 $\mu$m). The film is amorphous, has a coercivity of about $2.2\pi$ At/m (550 oersteds), and is represented by the formula $Fe_aN_b$ wherein a is about .6 and b is about .4.

### Example 3

Example 1 is repeated except that the argon pressure is about 7.9 Pa (60 $\mu$m) and the time is about 2400 seconds. The film is amorphous, has a coercivity of about 2 At/m (500 oersteds), and is represented by the formula $Fe_aN_b$ wherein a is about 0.6 and b is about 0.4.

### Example 4

Example 1 is repeated except that the argon pressure is about 6.66 Pa (50 $\mu$m). The film is amorphous, has a coercivity of about $1.6\pi$ At/m (400 oersteds), and is represented by the formula $Fe_aN_b$ wherein a is about 0.64 and b is about 0.36.

### Example 5

Example 1 is repeated except that the argon pressure is about 3.33 Pa (25 $\mu$m). The film is amorphous, has a coercivity of about $0.8\pi$ At/m (200 oersteds), and is represented by the formula $Fe_aN_b$ wherein a is about 70 and b is about 30.

### Comparison Example 6

Example 5 is repeated except that a bias of about 50 V is applied to the substrate. The film is crystalline with a coercivity of only about $0.16\pi$ At/m (40 oersteds) and is not suitable for magnetic recording media. This example is shown by the point marked 6 in Figure 1.

### Example 7

Example 4 is repeated except that the temperature of the substrate is about −196°C (77 K). The film is amorphous, has a coercivity of about $2.2\pi$ At/m (550 oersteds), and is represented by the formula $Fe_aN_b$ wherein a is about 63 and b is about 37.

### Example 8

Example 1 is repeated except that the argon pressure is about 1.33 Pa (10 $\mu$m). The film is crystalline, has a coercivity of only about $0.36\pi$ At/m (90 oersteds), and is not suitable for magnetic recording media.

### Example 9

Example 1 is repeated except that the argon pressure is about 1.33 Pa (10 $\mu$m) and the substrate temperature is about −196°C (77 K). The film is crystalline, has a coercivity of only about $0.6\pi$ At/m (150 oersteds), and is unsuitable for magnetic recording media.

The coercivities of the films of Examples 1—9 are shown at the varying pressures and conditions in Figure 1. The films of Examples 1—5 and 7 have a magnetization of $4\pi$M of approximately $1.01 \mp 0.2$ T (10.1 ± 2 kilogauss). It is found that for films sputter deposited at $5 \times 10^{-5}$ m (50 microns) or more of argon pressure, the coercivity is equal to or greater than about $1.6\pi$ At/m (400 oersteds), and cooling the substrate produced additional increases in the coercivity. It was noted that films which were annealed at 250°C for 29 hours resulted in only a small decrease in the coercivity, but were still quite suitable for magnetic recording media.

### Example 10

The amorphous film prepared according to the procedure of Example 1 is tested for corrosion resistance by placing in a corrosion testing chamber having a gas mixture of 300 ppb $SO_2$, 400 ppb $NO_2$, 3 ppb $Cl_2$, and 40 ppb $H_2S$ at 20°C and 70% relative humidity. The linear flow rate of the gas is about 0.51 m/s (100 feet/minute). The film shows no weight gain for 3 days.

### Example 11

Example 10 is repeated except that the film prepared according to the procedure of Example 2 is placed in a corrosion testing chamber. This film survived 11 days in the chamber with a total weight gain of $4.4 \times 10^{-13}$ kg/m². This is the example illustrated in Figure 2 labelled amorphous.

### Comparison Example 12

Films prepared in the same general manner as Example 2, except that varying amounts of chromium were added to the target, are tested in a corrosion testing chamber for corrosion resistance. The films are partially crystalline and contain from about 6 to about 15 atomic percent chromium. The results obtained are illustrated in Figure 2.

Figure 2 is a graph which illustrates increase in weight in $10^{-9}$ kg ($\mu$-gr) plotted against time in chamber in days. All films tested have a surface area of about $1.27 \times 10^{-4}$ m². The chromium containing films had higher corrosion rates than the films of the present invention. It is noted that the film which contained about 15 atomic percent chromium, 45 atomic percent iron, and 40 atomic percent N had the highest corrosion rate.

It is seen from the above examples that in order for the films to have both high coercivity coupled with high corrosion resistance, that such films must be amorphous.

In addition, the amorphous films according to the present invention exhibit good hardness characteristics and are resistant to wear.

### Claims

1. A thin film of an amorphous magnetic material characterised in that the magnetic material comprises iron-nitride in which the atomic percent of iron is from 70% to 40% and the atomic percent of nitrogen is from 30% to 60%, said film having coercivity of at least $0.8\pi$ At/m and high corrosion resistance.

2. A thin film according to claim 1, in which the atomic percent of Fe in said material is from 70% to 50% and the atomic percent of N in said material is from 30% to 50%.

3. A thin film according to claim 1 or 2, in which said film has a coercivity of at least $1.6\pi$ At/m.

4. A thin film according to any one of claims 1 to 3, in which said film contains 0 to 2 atomic percent argon.

5. A method of producing a thin film of an amorphous magnetic material characterised in that the method comprises depositing onto a substrate a film of amorphous iron-nitride by diode sputter deposition of an iron-nitride target in the presence of an inert gas maintained at pressure of at least 3.33 Pa (25 $\mu$m), the atomic percent of iron in said amorphous magnetic material being 70% to 40% and the atomic percent of nitrogen in said material being 30% to 60%.

6. A method according to claim 5, in which the inert gas is argon.

7. A method according to claim 5 or 6, in which during the sputter deposition pressure is maintained from 3.33 Pa to 13.33 Pa.

8. A method according to claim 5, 6 or 7, in which a target of $Fe_{0.5}N_{0.5}$ is employed.

9. A method according to any one of claims 5 to 8, in which the substrate is made of quartz.

10. A method according to any one of claims 5 to 8, in which the substrate is made of glass.

11. A method according to any one of claims 5 to 10, in which the atomic percent of Fe is from 70% to 50% and the atomic percent of N is from 30% to 50%.

## Patentansprüche

1. Dünnfilm aus amorphem magnetischem Material, dadurch gekennzeichnet, dass das magnetische Material Eisennitrid mit 70 bis 40 Atomprozent Eisen und 30 bis 60 Atomprozent Stickstoff enthält, mit einer Koerzitivkraft von zumindest $0.8\pi$ At/m und hoher Korrosionsfestigkeit.

2. Dünnfilm gemäss Anspruch 1, bei dem der Atomprozentgehalt von Eisen zwischen 70% und 50% und der Atomprozentgehalt von Stickstoff zwischen 30% und 50% liegt.

3. Dünnfilm gemäss Anspruch 1 oder 2, bei dem der Film eine Koerzitivkraft von zumindest $1.6\pi$ At/m besitzt.

4. Dünnfilm gemäss einem der Ansprüche 1 bis 3, bei dem der Film zwischen 0 und 2 Atomprozent Argon enthält.

5. Verfahren zur Herstellung eines Dünnfilms aus amorphem magnetischem Material, dadurch gekennzeichnet, dass auf ein Substrat ein Film aus amorphen Eisen-Nitrid durch Diodensputtern auf ein Eisen-Nitridtarget in Anwesenheit eines inerten Gases bei einem Druck von zumindest 3,33 Pa (25 $\mu$m) aufgebracht wird, wobei der Atomprozentgehalt des Eisens in dem amorphen magnetischen Material zwischen 70% und 40% und der Atomprozentgehalt von Stickstoff im Material zwischen 30% und 60% liegt.

6. Verfahren gemäss Anspruch 5, bei dem das inerte Gas Argon ist.

7. Verfahren gemäss Anspruch 5 oder 6, bei dem während der Sputteraufbringung der Druck zwischen 3,33 Pa und 13,33 Pa gehalten wird.

8. Verfahren gemäss Anspruch 5, 6 oder 7, bei dem ein Target aus $Fe_{0.5}N_{0.5}$ verwendet wird.

9. Verfahren gemäss einem der Ansprüche 5 bis 8, bei dem das Substrat aus Quartz besteht.

10. Verfahren gemäss einem der Ansprüche 5 bis 8, bei denen das Substrat aus Glas besteht.

11. Verfahren gemäss einem der Ansprüche 5 bis 10, bei dem der Atomprozentgehalt des Eisens zwischen 70% und 50% und der Atomprozentgehalt des Stickstoffs zwischen 30% und 50% liegt.

## Revendications

1. Film mince en matériau magnétique amorphe caractérisé en ce que ce dernier comporte du nitrure de fer dans lequel le pourcentage atomique de fer est compris entre 70% et 40% et dans lequel le pourcentage atomique d'azote est compris entre 30% et 60%, ledit film présentant une coercivité d'au moins $0.8\pi$ At/m et une résistance élevée à la corrosion.

2. Film mince selon la revendication 1, caractérisé en ce que le pourcentage atomique de Fe dudit matériau est compris entre 70% et 50% et en ce que le pourcentage atomique de N dudit matériau est compris entre 30% et 50%.

3. Film mince selon la revendication 1 ou 2, caractérisé en ce qu'il présente une coercitivité d'au moins $1.6\pi$ At/m.

4. Film mince selon l'une quelconque des revendications 1 à 3, caractérisé en ce qu'il contient un pourcentage atomique d'argon compris entre 0 et 2%.

5. Procédé de réalisation de film mince en matériau magnétique amorphe, caractérisé en ce qu'il consiste à déposer sur un substrat un film de nitrure de fer amorphe par pulvérisation cathodique d'une cible en nitrure de fer en présence d'un gaz inerte maintenu à une pression d'au moins 3,33 Pa, les pourcentages atomiques de fer et d'azote contenus dans ledit matériau magnétique amorphe étant respectivement compris entre 70% et 40% et entre 30% et 60%.

6. Procédé selon la revendication 5, caractérisé en ce que le gaz inerte est de l'argon.

7. Procédé selon la revendication 5 ou 6, caractérisé en ce que lors du dépôt par pulvérisation, la pression est maintenue à une valeur comprise entre 3,33 et 13,33 Pa.

8. Procédé selon la revendication 5, 6 ou 7, caractérisé en ce que l'on utilise une cible en $Fe_{0,5}N_{0,5}$.

9. Procédé selon l'une quelconque des revendications 5 à 8, caractérisé en ce que le substrat est en quartz.

10. Procédé selon l'une quelconque des revendications 5 à 8, caractérisé en ce que le substrat est en verre.

11. Procédé selon l'une quelconque des revendications 5 à 10, caractérisé en ce que le pourcentage atomique de Fe est compris entre 70% et 50% et en ce que le pourcentage atomique de N est compris entre 30% et 50%.

FIG. I

FIG.2